Europäisches Patentamt

European Patent Office

Office européen des brevets

(11) Publication number: **0 258 497**
**A1**

## (12) EUROPEAN PATENT APPLICATION

(21) Application number: **86201490.9**

(22) Date of filing: **01.09.86**

(51) Int. Cl.⁴: **G03F 7/20 , H05K 3/34**

(43) Date of publication of application:
**09.03.88 Bulletin 88/10**

(84) Designated Contracting States:
**BE DE FR IT NL SE**

(71) Applicant: **Sullivan, Donald Fort**
**56 West White Oak Road**
**Paradise Pennsylvania 17562(US)**

(72) Inventor: **Sullivan, Donald Fort**
**56 West White Oak Road**
**Paradise Pennsylvania 17562(US)**

(74) Representative: **Petri, Stellan**
**SAB Industri AB Box 515**
**S-261 24 Landskrona(SE)**

(54) **High resolution liquid photopolymer coating patterns over irregular printed wiring board surface conductors.**

(57) Solder mask coatings of high resolution may be prepared based upon the characteristics of liquid photopolymers that are partially polymerized through the thickness of a layer on the surface of a substrate. In one embodiment two discrete polymerizing steps occur, the first of which is a partial polymerization obtained by radiating with the polymer surface exposed to air. This polymerizes the layer portion (25) unexposed to air adjacent the substrate surface and leaving the air exposed surface (21) in the liquid state. This step uses a photopatterning image (16) with a greater dimension of opaque pattern area (17) than that used in a subsequent step. High resolution is attained in the second step by surface contact of the image with the polymer. The radiation source in each case is non-collimated. A layer of liquid photopolymer is disposed upon its permanent substrate cured through only part of its thickness adjacent the substrate to leave a liquid tacky outer surface. Conversely by using a non-reacting oxygen free gas blanket over the liquid photopolymer surface a cry hard skin (60) crust is produced over a liquid polymer base on the substrate. This skin can of itself be a photo image for a second radiation step. The steps need not be separate but may be accomplished by moving a phototransparency into contact with the polymer surface during radiation.

FIG. I.

NON-COLLIMATED RADIATION

# HIGH RESOLUTION LIQUID PHOTOPOLYMER COATING PATTERNS OVER IRREGULAR PRINTED WIRING BOARD SURFACE CONDUCTORS

## Technical Field:

This invention relates to liquid photopolymer coatings on printed wiring boards, and more particularly it relates to methods for assuring sufficient thickness of the polymer coating over irregular surfaces with high resolution photopattern reproduction on liquid polymers of pastelike consistency, and the products so obtained.

## Background Art:

Liquid photopolymers of paste like consistency are in use for photopatterning coatings on printed wiring boards as evidenced by my US-A-4,424,089 for Photoprinting Process and Apparatus for Exposing Paste-consistency Photopolymers. In that art the photopattern image bearing surface is pressed into contact with the polymer to produce high resolution coating patterns with non-collimated radiation of low intensity permissible because the polymer does not have its outer surface exposed to air. It is important to keep heat down and photospeed up in this manner.

Liquid polymers are imaged in US-A-4,436,806 with the outer surface exposed to air thus requiring greater exposure energy and generating considerable heat. Furthermore to obtain high resolution coating patterns, collimated radiation is required to eliminate the noise from scattering at the interfaces and particularly from the air gap interface.

When the liquid polymer layers are superimposed over irregular surfaces, such as those encountered on printed wiring boards having conductor traces extending about 0.025 mm above the substrate surface, they have the significant advantage of covering the rough surface without entrapment of air, which would lower resolution and adversely affect curing and adhesion.

However when the phototool with image, generally a flexible film layer, is pressed into place into intimate air free contact with the liquid polymer layer superimposed over the wiring traces, then the liquid polymer tends to be displaced from the wiring traces and thinned or starved. Thus, the following photopatterning step will leave a deficient thickness of covering over the wiring traces. When solder masking is required, for example, a layer of substantial thickness is required over the conductors for proper adhesion, insulation and resistance to the heat and stresses of soldering. This problem is addressed by this invention.

Another problem introduced by the use of non-collimated radiation is the inconsistency with high resolution patterns. Thus surface interfaces, such as between a liquid polymer layer and a plastic film carrying the desired image pattern, can cause reflections of the radiant energy which introduces noise tending to polymerize the polymer in unwanted places. Thus in printed wiring boards undercutting may occur to cause reduced adhesion, short circuits, open circuits or the like. This has been resolved by using collimated radiation for photoexposure, which is expensive.

It is therefore a general object of this invention to resolve the problems of the prior art as set forth hereinbefore to obtain high resolution photopatterning of liquid polymers using uncollimated radiation.

It is a further object of the invention to provide a method of producing superior products with high resolution photoimaged patterns produced with liquid photopolymers, with low photo energy and resulting heat while resolving problems of flow of the liquid polymer off of roughly contoured surface peaks, such as produced by conductor traces superimposed on the surface of a printed wiring board substrate.

Another general object of the invention is to produce a cured polymer layer in its permanent substrate position which has a tacky surface for further processing.

## Disclosure of the Invention:

This invention resolves the inconsistent properties and photoresponse characteristics presented when it is desired to use inexpensive liquid photopolymers and inexpensive non-collimated radiation of low energy level to produce high resolution photopatterns with assurance of adequate thickness of the liquid photopolymer superimposed on conductor traces or other surfaces protruding from the substrate surface of a printed wiring board, even when a phototool image is pressed into air excluding intimate contact with the liquid polymer.

The property of the liquid photopolymers that polymerization is inhibited by air is employed in this invention to reduce stray noise effects from uncollimated radiation, so that high resolution images may be produced. Thus, considerably greater radiant energy is required to polymerize the liquid polymer when the surface is exposed to air. However this is inconsistent with the high resolution desired, where surface contact of the phototool carrying the image to be reproduced is required. To resolve this inconsistency the photopatterning process takes place partially with the phototool in surface contact and partly with the phototool separated by an air gap from the surface of the liquid polymer.

In a first embodiment two sequential photopolymerization steps respectively are made through separate photo images, with an air exposed polymer surface in the first step and the image in contact with the polymer surface in the second step. The first and second images are related by having the opaque portions of different areas. The first photo step with the air gap is then taken with the larger area opaque pattern image with enough radiant energy to polymerize only the portion of the polymer layer thickness adjacent the substrate carrying the layer and therefore not exposed to air. This substrate, typically a printed wiring board with superimposed wiring traces extending from the substrate surface, then has the polymer layer polymerized to a depth covering the wiring traces with sufficient thickness, typically 0.025 mm, to assure a good solder mask coat for example. Then a liquid unpolymerized outer surface layer permits the intimate air free lamination of the second image into surface contact, so that about the same amount of radiation energy will polymerize the polymer layer throughout its depth. Therefore with the final imaging step through the desired pattern with less opaque image area the high resolution final image is prepared. The liquid polymer in all cases has pastelike consistency when laid down and merged with the image carrying phototool by squeegee pressure as taught in my US-A-4,424,089. The advantage of this embodiment is the assurance that the squeegee pressure does not displace or starve the liquid polymer layer over the edges of the wiring traces, but rather assures a minimum acceptable thickness of polymerized polymer over such surface irregularities.

In a second embodiment the partial surface contact is achieved with a contoured phototool surface with the transparent portions of the image in surface contact with the polymer and the opaque portions separated by an air gap from the polymer surface. Thus any stray radiation resulting from the non-collimated source at those areas where polymerization is not wanted is inhibited by the air-inhibiting characteristic of the polymer. This has the advantage of a single radiating step and a single phototool image.

More generally the invention is directed to a partial curing of a liquid photopolymer through its thickness with a desired pattern in its permanent substrate position to leave the outer surface tacky for further processing. The further processing may be typically a higher resolution photocure through the full layer thickness. Thus a liquid photopolymer layer in permanent place on its substrate is photocured through a selected opaque phototool pattern shape in two successive radiation steps, with differing areas imaged, the first radiation step producing an intermediate product condition and the second radiation step producing a permanent product condition. The second step typically is one of high resolution obtained by contact printing of an image in surface contact with a tacky liquid state surface portion of the polymer layer.

Another embodiment provides the feature of curing through an off-contact image with uncollimated radiation a liquid photopolymer layer partly through its thickness. This forms an outer skin crust thereon by means of photoexposure through a non-reacting oxygen free gas gap between a photo image transparency and the liquid photopolymer surface. This crust permits contact printing with the photo image during a second photoexposure step to produce high resolution, low energy polymerization without extruding liquid state polymer covering printed wiring extending from the substrate surface.

A first liquid photopolymer layer may be screen printed and a second photoexposure step used for curing the photopolymer with high resolution.

Furhter objects, features and advantages of the invention will be found throughout the following description, drawings and claims.

## Brief Description of the Drawings:

In the drawings:

Fig. 1 is a fragmental section view of a printed wiring board and phototool in a first photoimaging process step using non-collimated radiation,

Fig. 2 is a fragmental section view of a printed wiring board and phototool in a second photoimaging process step using non-collimated radiation,

Fig. 3 is a fragmental section view of the printed wiring board product obtained from the process steps of Figs. 1 and 2,

Fig. 4 is a fragmental section view of a printed wiring board and phototool radiated by non-collimated radiation in accordance with a second embodiment of the invention,

Fig. 5 is a fragmental section view of a printed wiring board undergoing a second photopolymerization step with a photoimaging transparency in contact with the polymer surface, and

Fig. 6 is a fragmental section view of a printed wiring board having thereon a screen printed low resolution liquid polymer pattern undergoing a photo polymerization step for producing a high resolution end pattern conforming with a phototransparency image pattern.

**The Preferred Embodiments:**

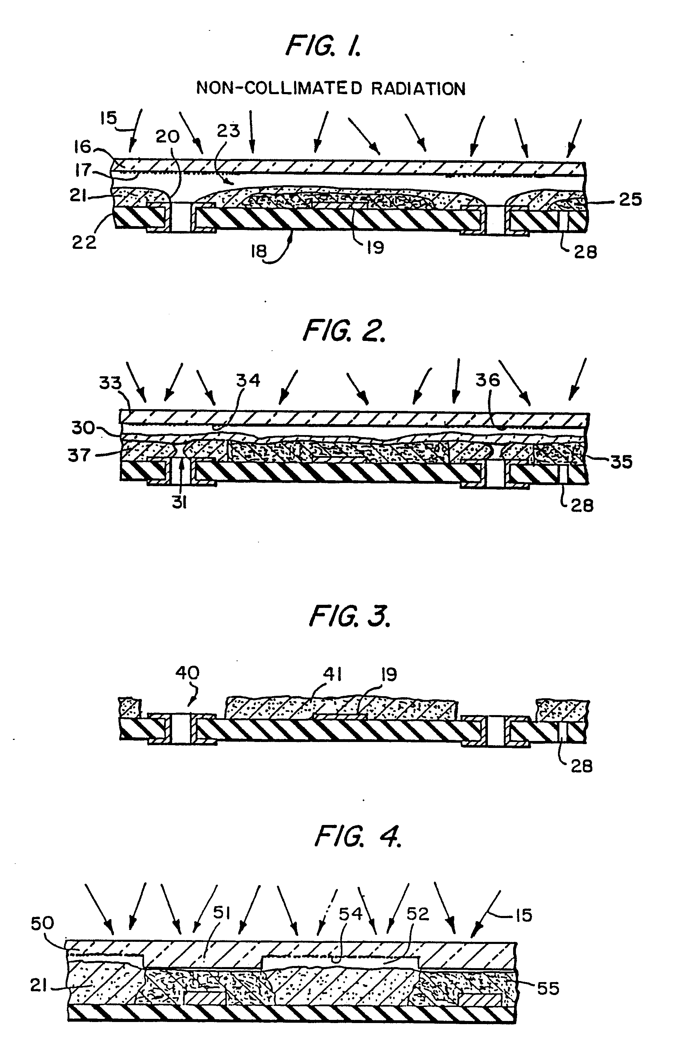

As may be seen from Fig. 1 non-collimated radiation, indicated by arrows 15, is directed through a phototool transparency 16 having opaque image forming patterns 17 thereon for selectively blocking out the radiation. For purposes of this invention non-collimated radiation is such radiation that significant energy is contained in rays that are non-parallel, thereby tending to cause reflections at interface surfaces and particularly air-to-plastic surfaces, which have enough misdirected energy to cause undersirable curing of the polymers.

The image pattern typically is used for photoimaging solder mask coatings on the printed wiring board 18 to cover wiring traces 19 and leave through hole connection pads 20 free to receive solder. A photopolymer layer 21 is superimposed over the surface of the wiring board 18, covering both the insulation panel substrate 22 surface and the wiring 19 and other surface irregularities superimposed thereupon. The lightly dotted stippling indicates the polymer in liquid paste consistency form and the heavy stippling the polymer in polymerized form as converted when subjected to radiation through the transparency 16.

Polymers as used in this invention may be either (1) those with free radical photo-initiators which react substantially instantly to radiation for polymerization, and thus are preferred for low energy fast response, or (2) cationic curing substances which gradually convert some ingredients to acids during radiation for acid curing of the remaining ingredients.

An air gap 23 is disposed between the phototool 16 and the surface of the polymer 21 by appropriate mounting of the substrate and the phototool. The properties of the liquid photopolymer selected cause its polymerization in response to radiation to be inhibited in the presence of air. Thus the radiation 15 passing through the transparent regions of the phototool 16 will polymerize the darkly stippled underneath portions 25 of the polymer layer disposed on the substrate surface and thus not exposed to air, while the surface exposed to air remains in liquid form. The radiation energy can be controlled to control the thickness of the liquid surface and the polymerized lower portion. The conductor trace 19 is thus covered with a hardened polymerized layer of the photopolymer. Typically, the conductor 19 extends about 0.025 mm from the substrate surface, the liquid polymer layer is about 0.075 mm thick and is polymerized about 0.050 mm to leave a liquid polymer depth of about 0.025 mm. This assures a minimum acceptable solder mask covering of at least 0.025 mm thickness. Otherwise had the phototool 16 been pressed, such as by squeegee action, into contact with the liquid polymner surface the thickness over the conductor would tend to be starved, particularly at the corners of the conductor trace 19, by being drawn into the gaps between the traces, etc. Other surface irregularities can cause the same effect.

The foregoing step gives very poor resolution for several reasons. The non-collimated radiation 15 with the air gap 23 will cause a spreading of the pattern from the desired area exactly under the transparent regions of the phototool image. Also reflections from the surface interfaces will cause noise that tends to disturb high resolution reproduction, although it is significantly inhibited by the air surface exposure of the liquid polymer. In addition the phototool has oversized opaque regions 17, which do not correspond with the eventual desired high resolution pattern.

Note that this process is also particularly advantageous for tenting over holes 28 in the printed wiring board substrate. In the printed wiring board arts, particularly where solder mask coatings are desired, the hardened polymer surfaces inhabit about 85% of the surface area, leaving about 15% with the polymer removed, from those areas generally defined in negative type polymers by about 15% opaque consistency of a phototransparency image used in the radiating process step.

Accordingly the second radiation step as illustrated by Fig. 2 is provided by this invention starts with a significant portion of the polymer area cured. The printed wiring board 18 following the preceding exposure step of Fig. 1 is now overlaminated with a clear plastic thin film layer 30 by means of a squeegee or the like. This may tend to squeeze a little of the liquid form polymer into the through holes as at 31. However the broad base polymerized regions 25 of Fig. 1 support the squeegeeing step with little rearrangement of the liquid polymer state outer surface layer and certainly provides a further thickness of polymer over the conductor traces to be shielded and insulated in the solder bath process of solder mask coating embodiments.

The thin plastic film transparent layer 30 can serve as a phototool by having the final image pattern opaque regions carried thereby. However if this gives registration problems, a superimposed phototool 33 may be used wherein the opaque regions 34 are in close proximity with the liquid polymer surface in order to assure high resolution final reproduction. The surface may have some irregularities, exaggerated in the drawing, but since the air is excluded from the polymer surface it is more sensitive to radiation and the final polymerization step can take place with about the same radiated energy as before used to simplify equipment cost. Thus, this is a 'contact' printing step that gives high resolution faithfully reproducing the image borne by phototool 33.

In this step the finally polymerized regions 35 are defined by the opaque image portions 36 of lesser area than those of Fig. 1. Thereby any poor resolution reproduction from the off contact printing step of Fig. 1 is simply covered to increase the extent of fully polymerized surface area and the unpolymerized liquid state polymer 37 remaining is simply washed out to form the solder pad regions 40 in the final product shown in Fig. 3. Therein the covering thickness of hardened polymer 41 over the conductor trace 19 is that obtained in Fig. 1 with the additional thickness, typically 0.025 mm, of the liquid layer, now polymerized.

In the embodiment of Fig. 4, only a single radiation exposure step is required. Here again the resolution is increased by using the photopolymer property that polymerization is inhibited in the presence of air. There can be noise introduced for example by pinholes in the phototool image opaque regions, in addition to the reflections, etc. hereinbefore described when inexpensive non-collimated radiation is employed. In this embodiment to correct for this, a relief surface on the contact face of the phototool 50 is provided with the transparent regions 51 in contact with the liquid polymer 21 and an air gap 52 disposed between the opaque regions 54 and the surface of the polymer 21.

In this way the polymerized regions 55 result from the contact printing step due to the radiation 15, while the polymer remains in liquid state beneath the opaque regions 54. Because of the air gap 52 much greater radiation power would be needed to make the stray radiation from the non-collimated radiation source effective for polymerization causing noise. Thus high resolution photopatterning is effected with a single radiation step while improving that resolution obtained with full contact of an entire phototool surface.

In particular this invention provides for the partial curing through the thickness of a liquid polymer layer in residence in permanent position on a substrate to leave a tacky liquid outer surface for further processing and a cured hard patterned underlying layer that may cover wiring patterns or irregular surfaces with a known thickness of cured and· hardened polymer. This permits a first radiation step of controlled radiation energy to cure only from the desired depth down to the substrate. This is less critical when an air sensitive polymer is used with an air surface during exposure.

Excellent resolution may be obtained by contact printing on the tacky surface with a final photopattern after a first non-contact air interposed first printing step in an approximate or other preliminary pattern.

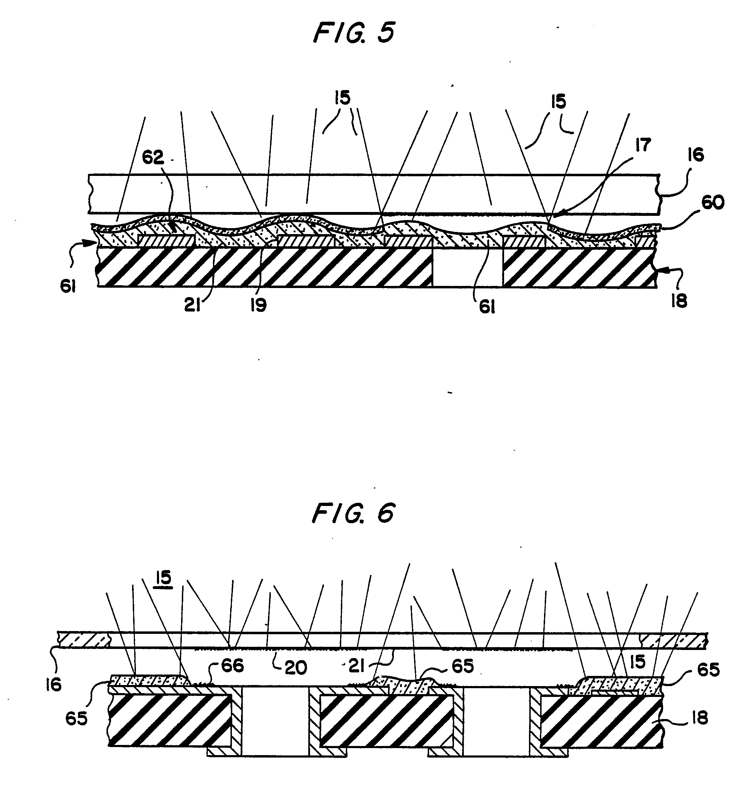

In a further embodiment of the invention, the air gap shown in Fig. 1 between the phototransparency 16 and the surface of the liquid photopolymer is replaced by a gas which neither reacts with the photopolymer or contains oxygen, such as argon or nitrogen. In this way the surface polymerization is not inhibited or quenched. By controlling the amount of radiation energy then a polymerized skin of dry polymer 60 is produced overlaying the liquid polymer base layer 61 as better seen in Fig. 5.

This skin layer 60 of about 0.025 mm thickness over wires 19 extending about 0.025 mm above the substrate 18 surface leaves a thickness of about 0.050 mm in the part of the thickness 62 covering the conductor wires with a 0.075 mm thick polymer layer 61 in a typical wiring board configuration. Because of the hardened dry polymerized skin 60, the liquid polymer 62 is not extruded from over the wires when the phototransparency is forced into surface contact with the polymer skin 60 surface.

Thus, with contact printing in the second photoexposure step through the phototransparency 16, better resolution is possible because of less stray radiation from uncollimated rays 15. Also less radiation energy is required because of surface coverage to exclude air of both the cured skin portion 60 and of the in-contact phototransparency 16.

With this skin cured surface 60, it per se becomes a phototransparency mask from which the second exposure step can result without the intervening phototransparency 16. Thus the oxygen inhibiting characteristic of the liquid photopolymer will prevent care of the non-skin covered area 61 when enough radiation is passed through skin 60 to the uninhibited oxygen free surface of the liquid polymer base layer 61 to polymerize the rest of the entire photopolymer layer thickness. A typical oxygen sensitive photopolymer is sold by W.R. Grace Company as "Unimask 2000". A one KW mercury vapor UV lamp at a distance of about one meter will form the skin to a thickness of 0.025 mm with a four second exposure time.

With the two exposure steps using a gas blanket to prevent oxygen inhibition in the gap (Fig. 1), resolution is bettered by a radiation source further away from the polymer surface, thereby reducing stray energy effects. The short flash of energy is enough to polymerize the skin and this also keeps stray energy from reducing resolution.

The two steps need not be separated but the radiation source may be programmed to move nearer for the second exposure (Fig. 5). The phototransparency may be programmed to move into surface contact since the skin 60 hardens quickly to support the phototransparency pressure on its surface.

The off-contact exposure (flash) step can be about one-fifth the duration of the second exposure step. The on-contact second exposure step then bonds the liquid polymer to the substrate surface, and is more energy efficient with a closer radiation source, and can even occur without the non-reactive gas in an air atmosphere because of the skin 60 covering the surface of the liquid polymer area to be polymerized to prevent oxygen inhibition.

In one embodiment the screen 16 is a fine mesh fabric permitting gas to be passed back through to blanket the polymer surface. This increases production speeds, and with the non-collimated light rays there is not any shadowing of the mesh into the curing pattern on the polymer surface. It also helps resolution by preventing deviations of rays from vertical to reduce the effect of stray light distortion.

By use of a mixture of inert gas and air as a blanket, the photosensitivity of the polymer may be controlled. It is found desirable when using a thin plastic lamination 30 (Fig. 2) to have a wet or tacky contact surface rather than a dry hard skin 60 (Fig. 5). Thus to achieve both a tacky surface and a fast photoresponse a controlled mixture of typically 90% argon and 10% air significantly reduces exposure time over an air surface and leaves the surface wet.

In this invention the feature of photoexposing a layer of photopolymer in situ on a substrate surface with uncollimated energy just sufficient to polymerize the layer through a portion of its thickness permits several advantageous process steps for achieving novel and useful functions. One advantage is that resolution can be improved in several ways. Thus, as shown in Fig. 6, the uncollimated radiation rays through phototransparency 15 with opaque areas 20 and transparent areas 21 serves to improve the resolution of a patterned liquid photopolymer layer 65 laid down by a screen printing on the surface of substrate 18. Smears or smudges 66 at the edges of the patterns result from the screen printing which reduces resolution.

Thus, the conventional step of radiation or baking of the pattern 65 to cure it is changed. Rather a photopolymerization step is introduced and a photopolymer is used. Then the image pattern 20 is used to improve the screen resolution at the edge 66 of the pattern.

Non-collimated radiation 15 can be used to produce high resolution patterns in the embodiment because of the air inhibiting quality of the liquid photopolymer layer 65. The amount of radiation energy is thus metered to polymerize the liquid photopolymer layer partly through its thickness from the substrate 18 surface upwardly to leave a surface layer of unpolymerized liquid photopolymer. When this is washed off it removes the smears 66 and produces a high resolution pattern corresponding to the opaque image portion 20 of the phototransparency 16.

**Claims**

1. The process of photoprinting patterns of polymerized photopolymers including the steps of: depositing onto a substrate surface a layer of liquid photopolymer having the characteristic that its photoresponse is inhibited by air contact with the photopolymer surface, and
photoexposing the layer of photopolymer in situ on the substrate surface through an image bearing phototransparency spaced away from the photopolymer surface by a gap with a non-collimated radiation energy polymerizing source providing only enough polymerizing energy to polymerize the photopolymer layer through a portion of its thickness.

2. The process defined in Claim 1 further comprising the steps of:
blanketing the surface of the liquid photopolymer layer with a non-reacting oxygen free gas during the photoexposing step thereby to effect the polymerizing of the photopolymer layer to produce an outer polymerized skin surface over a liquid polymer base portion of the thickness disposed on the substrate.

3. The process defined in Claim 2 further comprising the steps of:
limiting the time of photoexposure to a short flash that prevents any stray radiation from the non-collimated source from striking the photopolymer surface with enough energy to polymerize the photopolymer skin in areas defined by opaque areas of the phototransparency image, thereby to prevent significant resolution losses from the presence of non-collimated polymerizing energy.

4. The process defined in Claim 2 further comprising the step of:
providing a further photopolymerizing step with enough non-collimated polymerizing energy from a suitable source directed through an image bearing phototransparency in contact with the skin surface of the photopolymer layer to fully polymerize the photopolymer layer through its thickness and bond it to the substrate surface over a high resolution image pattern defined by the photo transparency image afforded by contact printing so that stray energy from the non-collimated source is not effective in significantly deteriorating resolution.

5. The process defined in claim 4 comprising the further step of:
providing the further polymerizing step in an air atmosphere wherein the contact of the phototransparency with the photopolymer surface and the prior polymerized skin surface substantially shield the surface of any polymer in liquid state from air so that the photopolymer polymerization thereof is not inhibited thereby and the polymerization therefore is energy efficient.

6. The process defined in Claim 4 further comprising the step of:
locating the radiation source in the first photoexposing step a greater distance away from the substrate than the radiation source is located in the further polymerizing step, whereby the resolution from stray energy is improved by better directivity of the polymerizing energy in the first step and the energy efficiency of polymerization is improved by the higher energy of the source at a position nearer the polymer surface in the further polymerizing step.

7. The process defined in Claim 5 further comprising the step of:
decreasing the gap distance from that in the first photoexposing step to the contact with the skin surface by moving the phototransparency at a programmed rate while polymerizing the liquid photopolymer with a single continuously applied energy source.

8. The process defined in Claim 7 further comprising the step of:
moving a single polymerization energy source from a distance further removed from the photopolymer surface in said first photoexposing step at a programmed rate toward a distance closer to the photopolymer surface as the contact is made by the phototransparency with the skin surface.

9. The process defined in Claim 4 further comprising the step of:
moving a single polymerization energy source from a distance further removed from the photopolymer surface in said first photoexposing step to a distance closer to the photopolymer surface for the further photopolymerizing step.

10. The process defined in Claim 4 further comprising the step of:
replacing the non-reacting gas with air during the further photopolymerizing step.

11. The process defined in Claim 1 further comprising the step of:
blanketing the surface of the liquid photopolymer in the photoexposing step with a mixture in predetermined proportions of air and a non-reacting gas to produce an outer skin layer polymerized beneath the surface but having a thin tacky liquid photopolymer surface layer.

12. The process defined in Claim 2 further comprising the steps of:
providing a phototransparency on a mesh screen surface having opaque images affixed thereto and allowing gas to pass through the mesh, and passing the gas through the mesh screen in the blanketing step to uniformly and rapidly contact the liquid photopolymer surface.

13. The process defined in Claim4 further comprising the steps of:
providing a substrate with high relief patterns extending upward from a generally planar surface, providing a skin surface of enough strength to prevent any substantial extrusion of liquid photopolymer from the patterns with the phototransparency pressed into contact with the skin surface in the further polymerizing step.

14. The process defined in Claim 2 further comprising the step of:
providing a further photopolymerizing step with enough non-collimated polymerizing energy from a suitable source directed through the polymerized outer skin surface as a sole photo imaging device in this step to polymerize the liquid photopolymer in the pattern of the skin surface through its entire thickness.

15. The process defined in Claim 1 further compsing the steps of:
forming a low resolution pattern in said depositing step by screen printing on the substrate surface said layer of liquid photopolymer, improving the resolution of the pattern screen printed on the substrate surface by the photoexposing step to polymerize the liquid polymer in a pattern defined by said image bearing phototransparency in the presence of air at the liquid photopolymer surface, and removing a surface layer of photopolymer in liquid form thereby eliminating smudges and smears caused by the screen printing process at edges of the pattern and leaving the improved resolution pattern of polymerized polymer.

16. The process defined by Claim 1 further comprising the steps of:
providing on said substrate surface before said depositing step a printed wiring pattern extending upwardly from the substrate surface,

placing said image bearing phototransparency in a substantially parallel plane over the liquid photopolymer layer with an air gap separation therebetween,

providing said photopolymer of a pastelike consistency of a type having the property that the radiation required to cure it is greater when its surface is exposed to air, and

limiting the radiation energy to prevent stray radiation from the uncollimated radiation source form polymerising the liquid photopolymer outside areas shadowed by the phototransparency image, thereby to improve the resolution available from polymerization from a uncollimated energy source.

17. The process of Claim 16 further comprising the steps of:

furhter photo exposing the photopolymer layer to cure the layer through its thickness and bond it to the substrate surface .with an image bearing phototransparency in surface contact with the photoplymer.

18. The process of Claim 17 further comprising the steps of:

providing in the further photoexposing step a phototransparency with an image presenting reduced dimension opaque portions to define the cured polymer pattern.

19. The process of Claim 1 further comprising the steps of:

providing an air blanket over the surface of the photopolymer in the photoexposing step to produce an outer liquid polymer surface and cured photopolymer near the substrate surface,

overlaminating the surface of the liquid polymer after the photoexposing step to avoid air contact with the photopolymer surface, and

further exposing the liquid polymer layer through a phototrnasparency image to cure the liquid polymer layer through the remainder of its thickness.

20. The process of Claim 19 further comprising the steps of:

providing an image in the further exposing step with a pattern similar to that of the first photoexposing step but proportioned .to have opaque image portions of smaller dimensions, and

registering the last mentioned opaque image portions within unpolymerized areas of the polymer layer remaining after the first photoexposing step thereby to improve resolution.

21. The process defined in Claim 1 furhter comprising the steps of:

providing wiring conductors extending approximately 0.025 mm above the surface of the substrate surface before depositing said layer of liquid photopolymer,

depositing said layer in a thickness exceeding about 0.075 mm thick.

22. The process defined in Claim 21 further comprising the step of:

photoexposing the photopolymer with an air blanket on the surface of the photopolymer thereby to polymerize the photopolymer to a thickness of about 0.050 mm to cover the conductors.

23. The process defined in Claim 21 further comprising the step of:

photoexposing the photopolymer with a blanket of non-reacting oxygen free gas covering the photopolymer surface thereby to polymerize the outer skin surface of the liquid photopolymer to a depth of about 0.025 mm.

## FIG. 1.

NON-COLLIMATED RADIATION

## FIG. 2.

## FIG. 3.

## FIG. 4.

## FIG. 5

## FIG. 6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 081 977  (WESTERN ELECTRIC CO., INC.)  * Claims; Figures * | 1 | G 03 F    7/20  H 05 K    3/34 |
| | --- | | |
| A | EP-A-0 123 158  (E.I. DU PONT DE NEMOURS & CO.)  * Claims 1, 4 and 5 * | 1 | |
| | --- | | |
| A | US-A-4 411 931  (ARMSTRONG WORLD IND.) | 1,2 | |
| | --- | | |
| A,D | US-A-4 424 089  (D.F.SULLIVAN) | | |
| | ----- | | **TECHNICAL FIELDS SEARCHED (Int. Cl.4)** |
| | | | H 05 K  G 03 F  B 23 K |

The present search report has been drawn up for all claims

| Place of search | Date of completion of the search | Examiner |
|---|---|---|
| THE HAGUE | 29-04-1987 | SCHUERMANS N.F.G. |